# EUROPEAN PATENT APPLICATION

(11) **EP 0 981 119 A2**
(43) Date of publication of application: **23.02.2000**
(21) Application number: 99401899.2
(22) Date of filing: 26.07.1999
(51) Int. Cl.: G07F 17/32

(54) **Gaming system with linked display**

(30) Priority: 18.08.1998 US 135659
(71) Applicant: WMS GAMING, INC., Chicago, Illinois 60618 (US)
(72) Inventor: Demar, Lawrence E., Chicago, Illinois 60618 (US); Frohm, Erica, Chicago, Illinois 60618 (US); Brown, Duncan, Chicago, Illinois 60618 (US); Slomiany, Scott, Chicago, Illinois 60618 (US)
(74) Representative: Loisel, Bertrand

(57) **Abstract**

A system for linking gaming devices with a centralized mechanical or video display. The gaming devices each have a local mechanical or video display for displaying game activity. The system includes a controller which receives information from the gaming machines and triggers activation of the centralized display. Where one or more of the gaming devices are operated in a bonus game, the controller may trigger the display of a bonus game on the centralized display, thereby permitting greater visibility of the bonus game on the centralized display than would otherwise be possible from the local display.

## Description

### FIELD OF THE INVENTION

The present invention relates generally to gaming devices and, more particularly, to a system for linking one or more of such gaming devices with a centralized display.

### BACKGROUND OF THE INVENTION

Unattended gaming devices, such as slot machines, video poker machines and the like, have been a cornerstone of the gaming industry for several years. Such devices are popular with casino operators because they are relatively inexpensive to operate and maintain and, depending on the popularity of the device, can provide a significant source of revenue to the casino. The attractiveness of a particular gaming machine to the player (and hence the profitability to the operator) may be attributed to a number of factors, including the perceived likelihood of winning and the intrinsic entertainment value of the machine relative to other available gaming options. In general, the greater the perceived winning percentage associated with the game, and the more entertaining the game, the greater likelihood that the machine will attract frequent play and thereby produce greater revenues for the casino operator. Accordingly, from the standpoint of the gaming machine manufacturer, there is a continuing need to produce new types of games, or enhancements to existing games, which will attract frequent play by enhancing the entertainment value and excitement associated with the game.

One concept which has been successfully employed to enhance the entertainment value of a game is the concept of a "secondary" or "bonus" game which may be played in conjunction with a "basic" game. The bonus concept is the subject of EP-A-0 874 337 incorporated herein by reference. Generally, the bonus game is entered upon the occurrence of a selected event or outcome of the basic game (for example, a special symbol combination appearing on the reels of a slot machine), but is otherwise independent from the basic game and may thereby comprise any type of game, either similar to or completely different from the basic game. In one embodiment, for example, where the base game is a reel-type slot machine, the bonus game could be a simulated reel-type slot machine implemented on a dot-matrix display or other type of video display.

It will be appreciated, however, that virtually any combination of basic game and bonus game may be employed. Whatever combination is chosen, the bonus game is preferably designed so that it produces a significantly higher level of player excitement than the basic game, either because it provides a greater expectation of winning than the basic game, because it provides more attractive or unusual video displays or audio, or both. In one embodiment, for example, entry into the bonus game gives a lucky player a series of free trials in which the probability of winning each trial, or the "hit rate," is such that the player may expect to win seven out of eight trials. The player is permitted to keep playing and accumulating winnings from the bonus game until a losing trial occurs. The excitement of the bonus game may be further enhanced through accompanying audio features and/or entertaining graphic displays.

The excitement of gaming machines incorporating the "bonus" game concept is not confined to the player, but generally extends to other persons having the opportunity to observe and listen, and thereby vicariously participate in, the bonus game. Such vicarious participation in the game is desirable to both the viewer and the casino proprietor alike, because it is entertaining, promotes a festive atmosphere in the area surrounding the machine and may attract new players to the game. Heretofore, however, because of size limitations relating to the bonus game display in present-day machines, and because the audio speakers are usually confined within the enclosure of present-day machines, there is generally only a limited number of people in the immediate area of the machine who may observe the bonus game display and/or listen to the bonus game. There is accordingly a need for a system in which the excitement of the bonus game may be conveyed to a greater number of people, and which provides an opportunity to see and/or listen to the game at locations outside of the immediate vicinity of the actual "bonus" machine and its local display. The present invention is directed to satisfying these needs.

### SUMMARY OF THE INVENTION

In accordance with one aspect of the present invention, there is provided a gaming system linked to a centralized display. The gaming system includes a plurality of gaming machines each having their own local display. The local displays may comprise mechanical displays, video displays, or a combination of mechanical and video displays. A controller is connected between the gaming machines and the centralized display. The controller is adapted to obtain local display information from the gaming machines and communicate corresponding display information to a centralized mechanical or video display. The local display information may be obtained from a selected gaming machine operating in a bonus mode so that the centralized display shows a bonus game corresponding to that shown on the local display.

In accordance with another aspect of the present invention, there is provided a gaming system controller for linking a plurality of gaming machines, each having their own local mechanical or video display, to a centralized mechanical or video display. The controller includes a communications interface and a processor. The communications interface receives game activity information from the gaming machines. The processor evaluates the game activity information and identifies whether there are any gaming machines operating in a preferred mode. If there are any gaming machines operating in the preferred mode, the processor enters a feature mode in which it obtains display information from a designated one of the machines operating in the preferred mode and communicates the display information to the centralized display. The display information may comprise the local display of the designated gaming machine. Where the preferred mode is a bonus mode of the gaming machines, the display information may comprise a bonus game shown on the local display of the designated gaming machine.

Otherwise, according to another aspect of the present invention, if there are no gaming machines operating in the preferred mode, the processor enters an attract mode and triggers display of an attract mode animation on the centralized display. When operated in the attract mode, the processor is adapted to switch to operation in the feature mode if it identifies one of the gaming machines as entering the preferred mode.

### BRIEF DESCRIPTION OF THE DRAWINGS

The foregoing and other advantages of the invention will become apparent upon reading the following detailed description and upon reference to the drawings in which:
FIG. 1 is a perspective view of a gaming system with a linked centralized display according to one embodiment of the present invention;
FIG. 2 is a block diagram of a gaming system linked to a centralized video display;
FIG. 3a is a front view of a centralized video display which may be used in the system of FIG. 2;
FIG. 3b is a front view of a second form of centralized video display which may be used in the system of FIG. 2;
FIG. 4 is a simplified illustration of a spinning reel slot machine with dot matrix display which may be used in the system of FIG. 1;
FIG. 5 is an enlarged view of the payline area of the slot machine of FIG. 4;
FIG. 6 is a block diagram of a system controller which may be used in the system of FIG. 1;
FIG. 7 is a block diagram of a display controller which may be used in the system of FIG. 1;
FIG. 8 illustrates a communications packet format which may be used in the system of FIG. 1;
FIG. 9 is a block diagram of a gaming system linked to a centralized mechanical display; and
FIG. 10 is a front view of a centralized mechanical display which may be used in the system of FIG. 9.

While the invention is susceptible to various modifications and alternative forms, specific embodiments have been shown by way of example in the drawings and will be described in detail herein. However, it should be understood that the invention is not intended to be limited to the particular forms disclosed. Rather, the invention is to cover all modifications, equivalents, and alternatives falling within the spirit and scope of the invention as defined by the appended claims.

### DESCRIPTION OF SPECIFIC EMBODIMENTS

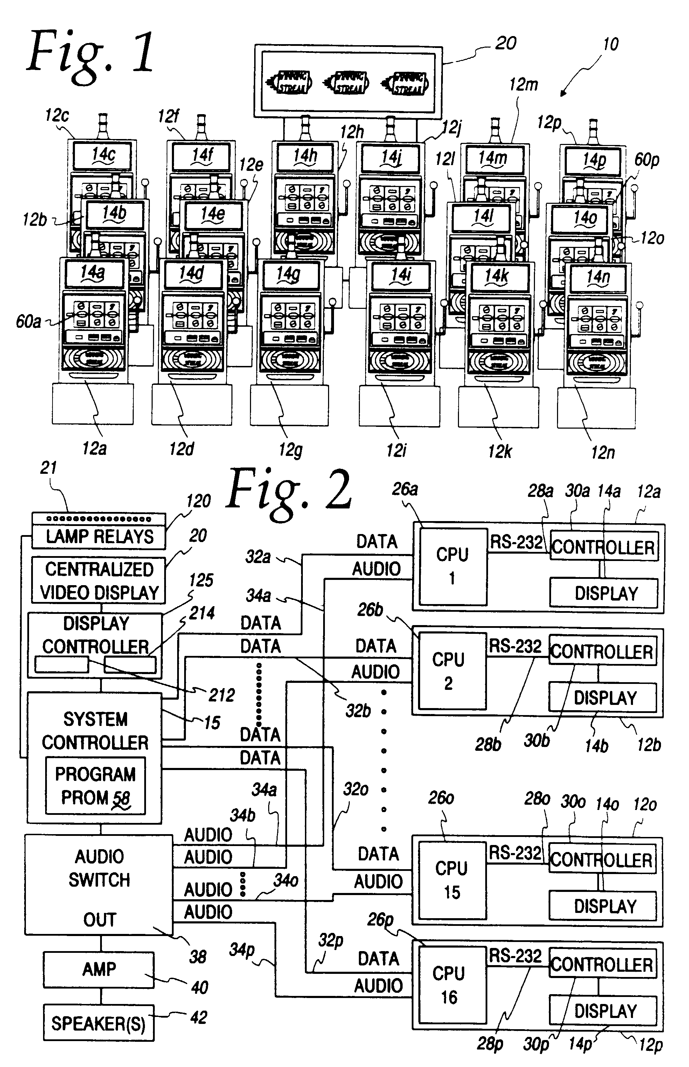

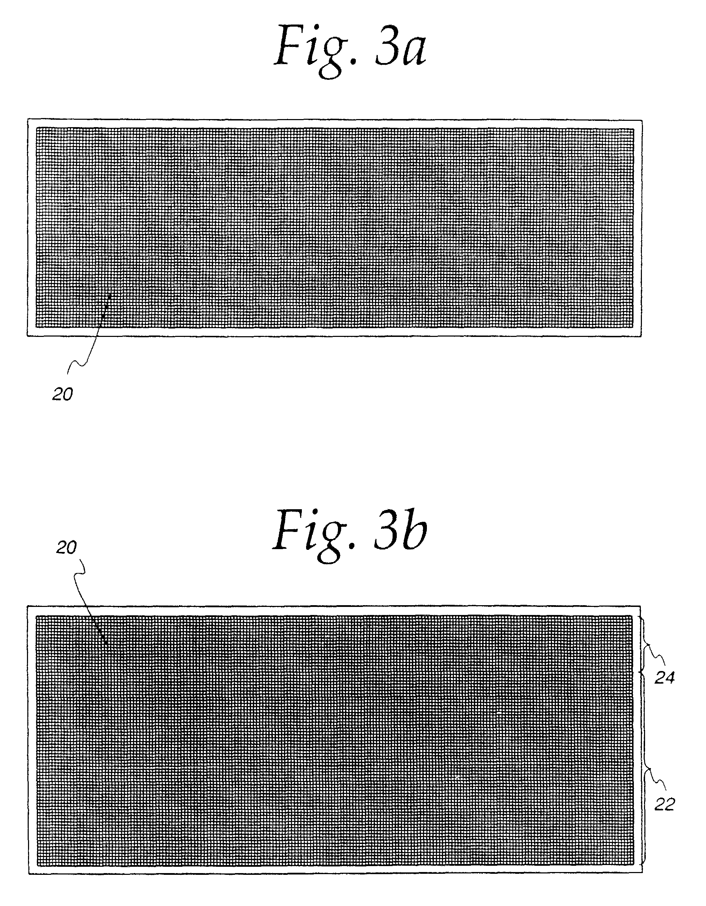

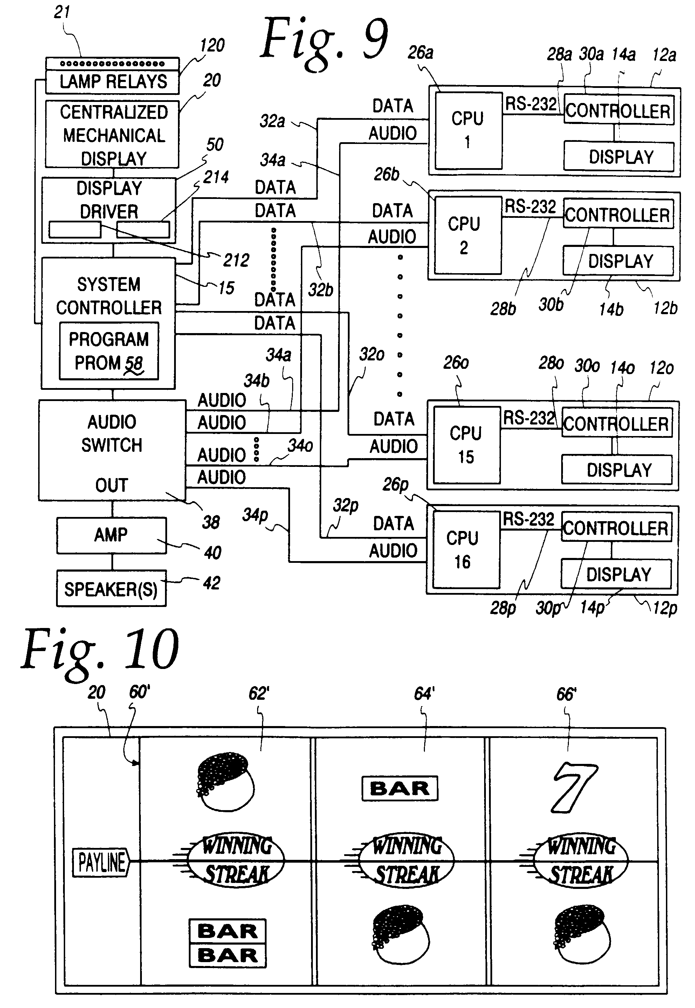

Turning now to the drawings and referring initially to FIG. 1, there is depicted one embodiment of a gaming system 10 with a linked centralized display 20. The centralized display 20 may comprise a video display (see FIGs. 2, 3a and 3b) or a mechanical display (see FIGS. 9 and 10). In the embodiment illustrated in FIG. 1, the gaming system 10 includes a bank of sixteen gaming machines 12a, 12b . . . 12p. It will be appreciated, however, that the system 10 may include fewer or greater numbers of gaming machines 12. At the lower extreme, for example, the system 10 may include only one gaming machine 12. A controller 15 and either a display controller 125 (for a centralized video display, see FIG. 2) or display driver 50 (for a centralized mechanical display, see FIG. 9) electrically or electronically link the gaming machines 12 to the centralized display 20. The centralized video or mechanical display 20 is adapted to display game information obtained from the gaming machines 12 by means of the controller 15 and display controller 125 (FIG. 2) or display driver 50 (FIG. 9).

In the illustrated embodiment (FIG. 1), the gaming machines 12a, 12b ... 12p comprise slot machines adapted for playing both a "basic" game and a secondary or "bonus" game. The "basic" game is the familiar game utilizing spinning reels, visible through display windows 60a, 60b ... 60p, to display game outcomes. The stop position of the reels illustrates whether a winning combination has occurred. The "bonus" game is a secondary game, shown on local displays 14a, 14b ... 14p, which may be entered upon a favorable outcome in the "basic" game. The local displays 14a, 14b ... 14p may comprise video displays, mechanical displays, or a combination of video and mechanical displays. It will be appreciated that the game(s) to be displayed on the local displays 14a, 14b,... 14p are not limited to "bonus" game(s). The local displays 14 may be utilized to show virtually any type of game, including "basic" game(s) and/or secondary game(s) other than "bonus" game(s). Moreover, the gaming machines 12 need not comprise slot machines, as illustrated in FIG. 1, but may comprise virtually any type of gaming machine or game of chance or skill (or combination of such games) utilizing a local video or mechanical display 14. Such games may include video poker or video blackjack games, for example.

A centralized video display 20 (FIG. 2) or mechanical display 20 (FIG. 9) may be used to display game activity from the local display 14 of a designated gaming machine 12. In one embodiment, the designated machine 12 is identified by the controller 15 to be a machine operating in a "preferred" mode. The preferred mode may be a "bonus" mode, a "basic" mode or any other defined mode of operation of the gaming machines 12. The centralized mechanical display may thereby be used to "mirror" the "bonus" mode or "basic" mode shown on the local display 14 of the designated gaming machine 12. Because the local displays 14 may comprise any combination of video or mechanical displays, there are at least four combinations of displays which may be utilized with the present invention:
(1) A centralized video display with a local video display;
(2) A centralized video display with a local mechanical display;
(3) A centralized mechanical display with a local video display; and
(4) A centralized mechanical display with a local mechanical display.
Speaker(s) 42 (FIGs. 2, 9) are provided for broadcasting an audio output associated with the designated machine. In the event there are no gaming machines 12 operating in a preferred mode, the controller 15 may communicate a defined "attract mode" sequence to the centralized display 20.

Generally, whether comprising a mechanical or video display, it is preferred that the centralized display 20 be sized and/or located to provide greater visibility relative to the local displays 14, so that the game activity displayed on the centralized display 20 may be more easily observed, or observed by a greater number of persons than would otherwise be able to see the designated gaming machines 12 and their local displays 14. Such greater visibility may be achieved in any of several ways, including but not limited to providing a centralized display 20 which is larger than the local displays 14 and/or positioning the centralized display 20 above the local displays 14.

In one embodiment, for example, where several gaming machines 12 are oriented in a circular "carousel" configuration and the local display 14 of a designated machine is operating in a bonus round, greater visibility of the bonus round may be achieved by communicating the local display 14 of the designated machine to one or more centralized displays 20 generally within the perimeter of the carousel. The centralized display(s) 20 may be larger than and/or positioned above the local displays 14 to increase the visibility of the centralized display(s) 20 relative to the local displays 14. The centralized displays may comprise planar displays or may be curved to approximate the contours of the carousel. In one embodiment, two centralized planar displays 20 are provided back-to-back in the center of the carousel so that one of the centralized displays 20 may be viewed from any point around the perimeter of the carousel. In such a configuration, whereas the circular geometry of the carousel would ordinarily prevent a viewer from observing any more than two or three of the several gaming machines (and thereby limit the opportunity to view the bonus round display), the centralized displays 20 ensure that viewers are able to observe the bonus round display at any point around the perimeter of the carousel.

It will be appreciated that there are several other alternative configurations of centralized display(s) which may provide increased visibility of the local display of a selected gaming machine. For example, where a plurality of gaming machines 12 are oriented in generally linear rows or columns, such that a designated gaming machine operating in the bonus round would otherwise be out of a viewer's line-of-sight or "blocked" by another machine, centralized display(s) 20 may be mounted on a wall or suspended from a ceiling adjacent to the gaming machines 12 in size(s) and/or location(s) that will permit anyone in the vicinity of the gaming machines 12 to view the bonus round. Alternatively or additionally, one or more centralized displays 20 may be positioned remotely from the gaming machines 12, so that viewers out of the immediate vicinity of the gaming machines 12 may observe the bonus round.

FIG. 2 is a block diagram of a gaming system 10 with a centralized video display 20. For convenience, like reference numerals will be employed to the greatest extent practical between FIGS. 1 and 2. Each of the gaming machines 12a, 12b ... 12p include a processor CPU 1, CPU 2, etc. (designated by reference numerals 26a, 26b . . . 26p), a local display 14 (designated by reference numerals 14a, 14b ... 14p), and a display controller/driver 30 (designated by reference numerals 30a, 30b ... 30p). The gaming machines 12 may comprise any game of chance or skill utilizing a CPU 26 and a local display 14. The local display 14 may comprise a mechanical display (such as a spinning reel display), a video display (such as a dot matrix, CRT or electro-luminescent display), or a combination of video and mechanical displays. The display controller/driver 30 may comprise a mechanical display driver (for a local mechanical display) and/or a video display controller (for a local video display). The gaming machines 12 may be provided in fewer or greater numbers than shown in FIG. 2.

Serial data cables 28a, 28b ... 28p connect the CPU 26 to the display controller/driver 30 in each of the gaming machines 12. The data cables 28, which may comprise RS-232 cables or the equivalent, support bi-directional communication between the CPU 26 and the display controller/driver 30 at a rate of 9600 baud, or approximately 1,000 bytes every second. In each gaming machine 12, the CPU 26 sends display information to the local display controller/driver 30 via the data cable 28. The display information includes operating conlmands for controlling the video and/or mechanical display of the gaming machines 12 and game activity commands for specifying modes of operation of the gaming machines 12 *(e.g.,* instructing the gaming machines to operate in "basic" or "bonus" mode).

Where the gaming machines 12 have local video displays, the display information includes packetized graphics instructions which specify, for example, frame animations, sprite animations, text printing and text banners to be displayed by the local video display controller 30. Where the gaming machines 12 have mechanical displays, the display information includes operating instructions for actuating elements of the mechanical display such as, for example, control signals specifying reel starting and stopping conditions of a spinning reel display. The graphics and/or mechanical display to be displayed by the gaming machines 12 may be associated with either a "basic" game or "bonus" game of the gaming machines 12.

In one embodiment of the present invention, the CPU 26 provides a combination of both video and mechanical display information to the display controller/driver 30 in each gaming machine 12. The video display information comprises packetized graphics instructions specifying frame animations, sprite animations, text printing and text banners to be displayed by gaming machines having a local video display, whereas the mechanical display information includes instructions for actuating the mechanical display in gaming machines having a local mechanical display. The mechanical instructions may include, for example, control signals specifying reel starting and stopping conditions of a spinning reel display.

The display controller/driver 30 in each gaming machine 12 is adapted to execute the video or mechanical operating instructions appropriate to its local display. Thus, the display controller/driver 30 in gaming machines 12 having local video displays execute the video operating instructions to operate their respective video displays and the display controller/driver 30 in gaming machines 12 having local mechanical displays execute the mechanical operating instructions to operate their respective mechanical displays. Display controller/drivers 30 in gaming machines having both local video and mechanical displays may simultaneously execute both the video and mechanical operating instructions to operate their respective video and mechanical displays.

In the system of FIG. 2, a gaming system controller 15 and a video display controller 125 link the gaming machines 12 to a centralized video display 20. The gaming system controller 15 and video display controller 125 may comprise physically different units, or may be contained within a single structure such as a personal computer. In the embodiment shown in FIG. 2, the gaming machines 12 are also linked through the system controller 15 to a plurality of player lamps 21 which may comprise, for example, incandescent lamps. The player lamps 21 are linked to the system controller 15 by a plurality of lamp relays 120. In one embodiment, the player lamps 21 correspond in number to the number of gaming machines 12 and are positioned near the centralized display 20. For example, the player lamps 21 may be positioned adjacent to *(e.g.,* on top of or below) the centralized display 20 The player lamps 21 may be selectively illuminated under operative control of the gaming system controller 15 to supplement the centralized display 20. It will be appreciated, however, that the centralized display 20 may be utilized with or without player lamps 21, or the player lamps 21 may be positioned apart from the centralized display 20. For example, player lamps 21 may be positioned on top each of the gaming machines 12 in addition to, or instead of player lamps 21 positioned adjacent to the centralized display 20.

Serial data cables 32a, 32b ... 32p are connected between the controller 15 and the CPU 26 of each of the gaming machines 12. The data cables 32, like the cables 28 in the gaming machines 12, may comprise RS-232 cables or the equivalent, and support bi-directional communication between the CPU 26 and the controller 15 at a rate of 9600 baud, or approximately 1,000 bytes every second. Each of the gaming machines 12 sends packetized display information, including operating commands for controlling a video and/or mechanical display and for specifying modes of operation of the gaming machines 12, to the controller 15 in substantially the same manner as to its local display controller/driver 30.

Because there is a possibility that the controller 15 may receive display information from each of the sixteen gaming machines 12 at the same time, the controller 15 must be capable of receiving and processing an effective data rate of 16,000 bytes per second. The controller processes the display information to identify a gaming machine operating in a preferred mode. The "preferred mode" may be a "bonus" mode, a "basic" mode or any other defined mode of operation of the gaming machines 12.

In one embodiment, where the "preferred" mode is a "bonus" mode, the display information includes "start bonus round" or "end bonus round" operating commands sent by the respective gaming machines 12 to the controller 15. The controller 15 continually evaluates the data carried by the data cables 32 to determine whether "start bonus round" commands have been received. Until the controller 15 receives a "start bonus round" command, the controller 15 remains in an "attract mode" and, through the display controller 125, communicates a defined attract mode graphics or animation sequence to the centralized display 20. The attract mode graphics provided to the centralized display 20 may comprise virtually any type of graphics or animation sequences such as, for example, scrolling or blinking banners, frame animations, and the like. FIG. 1, for example, shows one possible attract mode sequence in which three "Winning Streak" symbols are aligned in the center of the centralized display 20. In embodiments utilizing player lamps 21, the controller 15 communicates illumination instructions in which the player lamps 21 are directed to turn "on" or "off" in a predetermined manner. Where the controller 15 is in attract mode, such instructions will preferably define a sequence or pattern of illumination which will attract viewers to the player lamps 21, centralized display 20 and/or gaming machines 12. One possible pattern utilizing 16 player lamps (1,2,3 ... 16), initially all "off' and turned on at times T1, T2, T3, etc. is shown as follows.

| Time Lamps | ON |
|---|---|
| T0 | All Off |
| T1 | 1 |
| T2 | 1,2 |
| T3 | 1,2,3 |
| T4 | 1,2,3,4 |
| T5 | 1,2,3,4,5 |
| T6 | 1,2,3,4,5,6 |
| T7 | 1,2,3,4,5,6,7 |
| T8 | 1,2,3,4,5,6,7,8 |
| T9 | 1,2,3,4,5,6,7,8,9 |
| T10 | 1,2,3,4,5,6,7,8,9,10 |
| T11 | 1,2,3,4,5,6,7,8,9,10,11 |
| T12 | 1,2,3,4,5,6,7,8,9,10,11,12 |
| T13 | 1,2,3,4,5,6,7,8,9,10,11,12,13 |
| T14 | 1,2,3,4,5,6,7,8,9,10,11,12,13,14 |
| T15 | 1,2,3,4,5,6,7,8,9,10,11,12,13,14,15 |
| T16 | 1,2,3,4,5,6,7,8,9,10,11,12,13,14,15,16 |
| T17 | 2,3,4,5,6,7,8,9,10,11,12,13,14,15,16 |
| T18 | 3,4,5,6,7,8,9,10,11,12,13,14,15,16 |
| T19 | 4,5,6,7,8,9,10,11,12,13,14,15,16 |
| T20 | 5,6,7,8,9,10,11,12,13,14,15,16 |
| T21 | 6,7,8,9,10,11,12,13,14,15,16 |
| T22 | 7,8,9,10,11,12,13,14,15,16 |
| T23 | 8,9,10,11,12,13,14,15,16 |
| T24 | 9,10,11,12,13,14,15,16 |
| T25 | 10,11,12,13,14,15,16 |
| T26 | 11,12,13,14,15,16 |
| T27 | 12,13,14,15,16 |
| T28 | 13,14,15,16 |
| T29 | 14,15,16 |
| T30 | 15,16 |
| T31 | 16 |
| T32 | Repeat Sequence |

From the attract mode, upon receipt of valid "start bonus round" data from a first gaming machine 12, the controller 15 enters a "feature" mode in which it designates the first machine 12 as the "active" machine and communicates (or "features") display information from the designated machine 12 to the centralized video display 20 and/or the player lamps 21. The designated machine remains "active" until it sends "end bonus round" data or gives up control due to an inactivity timeout. In one embodiment, an inactivity timeout occurs when communications from the designated machine have stopped for five seconds.

In one embodiment, where the local display 14 of the "active" machine 12 comprises a video display (or a video display in combination with a mechanical display), the display information provided to the centralized display 20 includes video commands specifying substantially the same display information and display formats provided to the local display controller/driver 30 of the active machine 12. The video commands provided to the local display controller/driver 30 or the centralized video display 20 may be provided exclusively or in combination with mechanical operating commands.

In one embodiment, where the local display 14 of the "active" machine 12 does not have a video display *(e.g.,* where the local display 14 comprises only a mechanical display), the display information provided to the centralized display 20 includes video commands which are generated by the active machine but not provided to the local display controller/driver 30 of the active machine 12. Alternatively, the video commands may be provided to but not executed by the local display controller/driver 30 of the active machine 12. The video commands provided to the local display controller/driver 30 or the centralized video display 20 may be provided exclusively or in combination with mechanical operating commands.

It will be appreciated, however, that the video commands provided to the centralized display 20 may specify different display information and/or different display formats than that provided to the local display 14 of the active machine 12. For example, in one embodiment utilizing a high-resolution video monitor as a local display 14, the CPU 26 may provide packetized graphics instructions to the local display 14 specifying high-resolution frame animations, sprite animations, text printing and text banners to be displayed, whereas the graphics instructions provided by the CPU 26 to the centralized display 20 may specify lower resolution frame animations, sprite animations, text pnnting and text banners corresponding to the local display.

In one embodiment, the display information provided to the controller 15 includes information from which the controller may identify the machine number playing the active game or a win amount associated with the active game. In embodiments utilizing player lamps 21, for example, the controller 15 may receive information permitting it to identify the "active" machine so that it can cause the appropriate player lamp 21 to illuminate. Viewers can thereby identify the "active" machine by observing which one of the player lamps 21 is illuminated.

During display of the active game (while in the "feature" mode), the controller 15 continues to receive information carried by the data cables 32 to determine whether "start bonus round" data is received from any other machines 12. The receipt of "start bonus round" data from other machine(s) during display of the "active" game indicates that bonus game(s) other than the "active" game are in progress simultaneously with the "active" game. The controller 15 receives display information from such games but does not immediately designate them as "active." The controller 15 designates such games as "active," if at all, upon receipt of an "end bonus round" command (or inactivity timeout) from the first gaming machine 12. The receipt of the "end bonus round" command (or inactivity timeout) from the active machine causes the controller 15 to terminate the "active" status of that machine. Then, if there are other bonus games in progress, the controller 15 designates as "active" the first one of the new machines (having bonus games in progress) that sends "total rebuild" information to the controller. The "total rebuild" data indicates that the display information from a particular machine 12 is about to define a graphics sequence which will "totally rebuild" the video display. Receipt of the "total rebuild" data signals the controller 15 that it is an appropriate time to designate the particular machine 12 as the currently active game.

After having designated a new "active" game, the controller 15 causes display information to be sent from the newly designated "active" machine to the centralized display 20 and/or player lamps 21 in substantially the same manner as for the previous active game. The newly designated machine 12 remains "active" until it sends "end bonus round" data to the controller 15 or gives up control due to an inactivity timeout. The controller 15 will reenter the "attract mode" after having received "end bonus round" data from a recently active machine when there no other machines 12 in the bonus or preferred mode.

Alternatively or additionally, a variety of other display information may be provided to supplement or replace the "start bonus round," "end bonus round," and/or "total rebuild" packetized commands sent via the serial data cables from the gaming machines 12 to the controller 15. Alternative commands may be used, for example, to support an alternative display contention scheme in which a currently active game may be preeempted by another game before the currently active game has ended. Such a scheme may be implemented, for example, by a "preempt" or "display override" command sent by a designated game, causing the controller 15 to re-assign active status from the game in progress to the designated game, thereby terminating display of the game in progress and replacing it with display of the designated game. Another example might be an "award threshold" command used to identify a currently active game which has reached a particular award threshold, such that the controller 15 will preempt the display of a currently active game and feature instead the display of the game which has reached a particular award threshold. It will be appreciated that there are virtually an unlimited number of commands which may be utilized to provide display information in the present invention. The particular commands described herein are provided for exemplary purposes only and shall not be construed as limiting the scope of the invention.

An audio switch 38 is provided for linking an audio output of the designated "active" gaming machine 12 to an amplifier 40 and speakers 42. The audio switch receives audio outputs from the gaming machines 12 through respective line-level audio feeds 34a, 34b ... 34p. The audio switch 38 is operated by the controller 15 to switch the audio output of the designated "active" machine 12 to the amplifier 40 and speakers 42 for broadcast. If no machines 12 are active, the controller 15 may cause the audio switch 38 to feed the speakers 42 an audio output associated with an attract mode sequence as described above.

The controller 15 includes program PROM(s) 58 for storing control software, operational instructions and data necessary to control the functions of the controller 15, as well as operating instructions for passing packeted video commands and/or mechanical control signals from the active machine 12.

The display controller 125 includes a program PROM 212 and data PROM(s) 214. The program PROM 212 stores control software, intermediate instructions and data necessary to control operation of the centralized video display 20 in response to instructions from the controller 15. The data PROM(s) 214 store data relating to text printing, text banners, fonts, frames, sprites, frame animations and sprite animations to be displayed in relation to the "active" machine 12 (in "feature" mode) or in "attract" mode. In one embodiment, the program PROM 212 and data PROM(s) 214 in the display controller 125 (and the data contained therein) are exact duplicates of corresponding memory sections in the local display controller/driver 30 of the gaming machines 12. In another embodiment, the program PROM 212 in the display controller 125 is different from that of the local display controller/driver 30, but the data PROM(s) 214 in the display controller are identical to corresponding memory sections in the local display controller/driver.

It will be appreciated that the memory structures heretofore described (e.g., PROMs 58, 212 and 214) may comprise physically separate memory structures (e.g., stored on separate memory "chips") or may *comprise functionally* separate memorys integrated on a single memory structure. In one embodiment, each of the PROMs 58, 212 and 214 comprise erasable programmable read only memories (EPROMs). EPROMs are nonvolatile *(e.g.,* their data content is preserved without requiring connection to a power supply) and they are generally unalterable, unless removed and exposed to ultraviolet light. As will be appreciated, however, the memory structures 58, 212 and 214 may be comprised of any of several types or combinations of memorys known in the art, including volatile or writable memorys.

FIGs. 3a and 3b show alternative forms of a centralized video display 20 which may be used in the system of FIG. 2. Generally, in each of FIGs. 3a and 3b, the centralized display 20 comprises an LED (light emitting diode) display consisting of a matrix of individual LED elements. More particularly, in FIG. 3a, the centralized display 20 is composed of 12,288 elements, including 64 rows of 192 elements whereas, in FIG. 3b, the display 20 is composed of 15,360 elements, including 80 rows of 192 elements. In one embodiment, the individual LED elements are spaced apart by a distance of one-quarter inch or greater, so that the width of the centralized display 20 (spanning 192 elements) is at least four feet (48 inches). The display elements are separately actuatable, preferably at a rate of 25 full frames per second or more, to form a graphics display which may include, for example, animated characters, text or symbols.

The centralized video display 20 of FIG. 3a, having 64 rows of 192 elements, is designed to correspond exactly (in number and arrangement of elements) to a form of local video display 14 having 64 rows of 192 elements, such as a dot-matrix display. Thus, where the display information provided by the gaming machine 12 to the local display/controller 30 will support a local video display 14 having 64 rows of 192 elements, the same display information provided to the display controller 125 will produce a video image on the centralized display substantially the same as that shown on the local video display 14, with one-to-one correspondence between the "dots" or pixels of the local video display 14 and the individual LED elements of the centralized display 20. Accordingly, in this embodiment, an active game replicated from one of the local video displays 14 (or created from video display information provided by a gaming machine having a local mechanical display), will generally fill the entire matrix of LED elements composing the centralized display 20.

The centralized video display 20 of FIG. 3b, having 80 rows of 192 elements. includes 16 additional rows relative to the local video display 14 of the type described above. Thus, in this embodiment, the display 20 may be considered to include a first section 22 (having 64 rows) adjoined to a second section 24 (having 16 rows). The first section 22 will correspond exactly in number of elements to the form of local video display 14 described in relation to FIG. 3a. The second section 24 *(e.g.,* the 16 additional rows) provides the centralized display 20 the capacity to display an additional line of text, or some other designated characters or symbols, to supplement whatever is displayed on the first section 22. More particularly, where the display information provided by the gaming machine 12 to the local display/controller 30 will support a local video display 14 having 64 rows of 192 elements, as described above, the same display information provided to the display controller 125 may produce a video image on the first section 22 of the centralized display showing an "active" game from a designated machine and the second section 24 may be used to display a line of text corresponding to the "active" game. One possibility, for example, is to display a bonus game on the first section 22, and a designation of the active machine (or player) "number," and/or an associated "win amount" on the second section 24. In one embodiment, the line "PLAYER I" (or whichever machine is "active") is displayed in blinking letters on the second section 24. The data presented on the second section 24 may also be presented in scrolling text or virtually any format that may be displayed on 16 rows of 192 elements.

It will be appreciated that the centralized video display 20 may comprise any of several alternative types or modified forms of the displays shown in FIG. 3a and 3b. For example, the centralized video display 20 may comprise a CRT, LCD or electro-luminescent display rather than an LED display, or the centralized video display 20 may have a greater or lower resolution (e.g., having fewer or greater numbers of elements) or a different arrangement of elements than shown in FIG. 3a or 3b. The centralized video display 20 may comprise a cclor or monochrome display. In an embodiment where the centralized video display 20 comprises a monochrome display, the LED elements are preferably actuatable at three or more discrete intensity levels to emulate three or more shades of "gray."

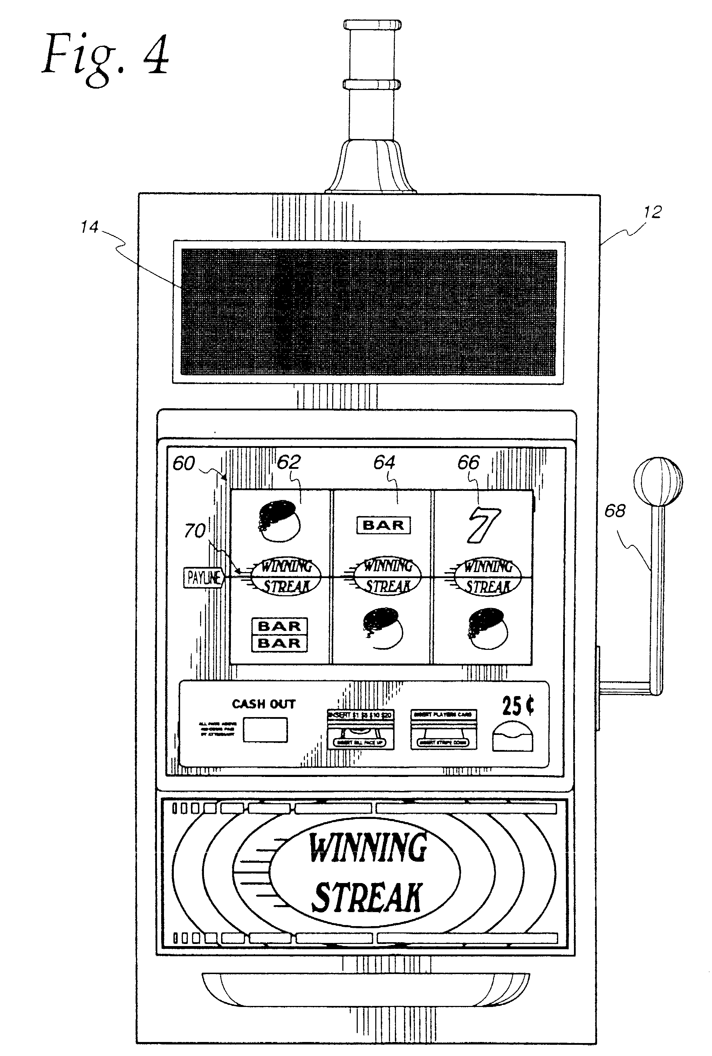

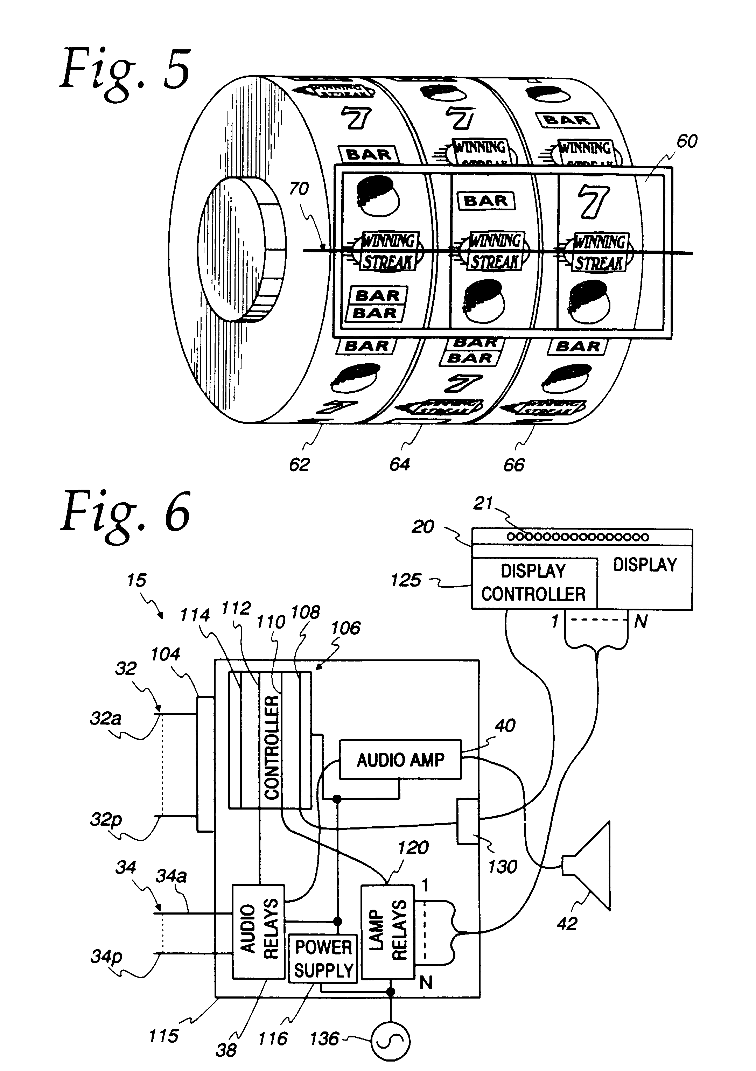

Now turning to FIGs. 4 and 5, there is shown a spinning reel slot machine 12 with dot matrix display 14 which may be used in the system of FIG. 1. It will be appreciated, however, that the slot machine 12 is exemplary only and the present invention is not limited to use with spinning reel slot machines, nor is the present invention limited to use with gaming machines having a dot matrix or any other type of local video display. The machine 12 includes a display window 60 through which a player may observe three spinning reels, 62, 64 and 66. "Basic" game play is initiated by inserting a coin or playing a credit and then either pulling the lever 68 or depressing a push button (not shown) on the slot machine 12. A CPU 26 (FIGS. 2, 9) then operates according to its game program to select a reel stop position for each of reels 62, 64 and 66. The stop position of the reels 62, 64 and 66 illustrates whether a winning combination has occurred.

Traditionally, a payoff or credit is awarded to a player when a winning combination of symbols is displayed on a center payline 70. The symbols may include, for example, Cherry, Single Bar, Double Bar and the like. In FIGs. 4 and 5, "Winning Streak" bonus game symbols are aligned on the center payline 70. Symbols are also visible above and below the center payline 70 of the reels 62, 64, 66. In machines 12 displaying symbols above and below the center payline 70, additional paylines or payoff features may be provided. In one embodiment of the present invention, for example, any combination of "Winning Streak" bonus game symbols visible on, above or below the payline 70 gives the player the opportunity to play a bonus game entitled "Winning Streak." The "Winning Streak" game is a secondary slot machine game which is generally more exciting than the "basic" game because it provides a greater expectation of winning than the basic game and is accompanied with more attractive video displays and audio. The "Winning Streak" game and payriables associated with the game are described in EP-A-0 874 337.

In the illustrated embodiment, the slot machine 12 is provided with a local video display 14 for displaying the bonus game. The local video display 14 may comprise a dot matrix, CRT, LED, electro-luminescent display or generally any type of video display known in the art. In the illustrated embodiment, the video display 14 is vertically disposed within an upper portion of the slot machine 12. It will be appreciated that the local video display 14 may be utilized to display any type of game, including a "basic" game or a bonus game other than the "Winning Streak" game such as, for example, a video poker game. Whatever game is displayed on the local video display 14 (or spinning reel display 60) may be displayed on a centralized video display 20 (FIG. 2) or centralized mechanical display 20 (FIG. 9).

Alternatively or additionally, the slot machine 12 may be provided with a secondary mechanical display (not shown), such as a secondary spinning reel display, for displaying a "basic" game or "bonus" game. Such a display may be used, for example, in the above-described "Winning Streak" game to display the bonus game on mechanical, rather than video, spinning reels. It will be appreciated, however, that secondary mechanical displays are neither limited to spinning reel displays nor the "Winning Streak" game, but shall be construed to include virtually any type of mechanical display that may be used to display a "basic" or "bonus" game of chance or skill. In any case, whatever game is displayed on the secondary mechanical display 14 may be displayed on a centralized video display 20 (FIG. 2) or centralized mechanical display 20 (FIG. 9).

FIG. 6 shows a system controller 15 which may be used in the system of FIG. 1 to link the centralized video display 20 to the respective gaming machines 12. The system controller 15 receives serial data cables 32a, 32b ... 32p which carry the relevant bonus game information or data at an input which preferably comprises a communications port header 104. The communications port header 104 communicates with a controller 106 which preferably incorporates a microcomputer board 108, a lamp controller board 110, an audio controller board 112 and a communication controller board 114. The controller is in turn housed within a control unit housing 115 which also houses a power supply 116 for supplying appropriate operating power for the various components thereof, as well as audio relays 38 which correspond to the audio switch 38 of FIG. 2 (or FIG. 9), lamp relays 120 and an audio amplifier 40 for driving audio speaker(s) 42. While any number of speakers may be utilized, the present embodiment illustrates a single loudspeaker. The computer board 108 drives a display controller 125 which is operatively associated with the centralized display 20.

While other equivalent parts and components may be utilized for each of the elements described above, specific parts and components are hereinafter described for purposes of fully describing one embodiment of the invention. In one embodiment, the microcomputer 108 is a single board computer such as a model IND-486 DX produced by Micro Computer Specialists Inc. This computer includes an Intel 486 processor operating with a 66 MHz clock, a 4 Mbyte PROMDISK, an RS-232 port and 2 Mbytes of DRAM. The 486 processor will provide enough processing bandwidth to handle communications traffic from the individual gaming machines 12. The 66 MHz clock provides a 15 Nsec cycling time. Assuming an average instruction requires four cycles, then each instruction will require 60 Nsec. The data transfer rate of the game units is 9600 baud or approximately I byte every 1 Msec. In the illustrated embodiment, the input port 104 may handle as many as 16 input lines 32 from 16 corresponding gaming machines 12. Since there is a possibility that all 16 ports could be transferring data at the same time, the processor may need to have an effective data rate of 16,000 bytes per second. The illustrated embodiment has the capability of bi-directional communications between the controller 15 and the individual game units. However, in the illustrated embodiment, data or information is transferred only from the individual game units 12 to the processor for use in operating the display 20 and speaker(s) 42. Given the 486 processor instruction execution rate (approximately 60 Nsec per instruction) and the maximum data transfer rate (9600 baud) the processor can execute approximately 1,000 instructions for each byte received at this rate (16,000 bytes per second). This provides a substantial margin for processor performance.

The 4 Mbyte PROMDISK will permit the controller to operate as an unattended embedded system. The PROMDISK in one embodiment is loaded with MS-DOS 6.22 command.com, autoexec.bat, config.sys and the necessary DOS device driver which will use less than 15 Kbytes of the drive. In addition, the application software for operating the display and audio will be installed on the PROMDISK, and it is estimated that this program will require less than 350 Kbytes, providing approximately 3 Mbytes of file space for additional expansion. An RS-232 port 130 is used to communicate with the display controller 125 at a 9600 baud rate.

In addition to the above-described elements, the IND-486 DX microcomputer also contains additional hardware features which are not utilized in the illustrated embodiment, including a second RS-232 port, an IDE disk port and a bi-directional parallel port. One or more of these features may also be used to facilitate additional software development and/or application.

The audio control hardware includes two elements. One element comprises an audio digital I/O (DIO) board 112 installed on the controller's back plane bus with the computer 108. The other component is an RB-24 relay board 38 which is mounted in the housing 115. These two boards are electrically connected by a 50 pin header flat cable. The DIO board is memory mapped into the computer's I/O space permitting the computer to communicate with the DIO board. In turn, each DIO bit will control the coil voltage of DPDT relays on the RB-24 relay board 38.

The audio signals from the individual game units 12 are carried on cables 34 and are input to the audio relays 38. In operation, under the control of the audio DIO board 112 a selected audio signal will be connected by the relays 38 to the audio amplifier 40 to drive the speaker(s) 42. In one embodiment, the audio amplifier 40 comprises a Symetrix two channel, 20 watt per channel audio amplifier that can also operate in mono mode and supply 40 watts to a single 4 to 8 ohm load. A volume control for adjusting the amplification (not shown) may also be provided.

In similar fashion to the audio control hardware, the lamp control hardware includes two circuit boards. One of these boards, the lamp controller board 110 is a digital I/O board (DIO) which is installed on the controller's back plane buss with the computer 108. The other board 120 includes an RB-24 relay board installed in the housing 115. The two boards are electrically connected by a 50 pin header flat cable. In similar fashion to the audio system, the lamp DIO board 110 is memory mapped into the computer's I/O space, permitting the computer 108 to control the DPDT relays on the RB-24 relay board 120. A 120 VAC source 136 will be connected to the common contact pair of each relay on the board 120. Thus, when the controller 15 is in "feature" mode, the relay may be closed to supply the 120 VAC to a designated one of the player lamps 21 (FIG. 2). Each relay of the RB-24 board is capable of handling one amp of current.

As heretofore described, the player lamps 21 comprise a number of lamps corresponding in number to the number of gaming machines 12 which can be accommodated by the system of the invention, which in the illustrated embodiment is 16. The player lamps 21 may be positioned adjacent to the centralized display 20 and/or on the individual gaming machines 12. It is contemplated that the player lamp 21 to be illuminated in "feature mode" will correspond to and thereby indicate the identity of the designated gaming machine 12 whose display is being shown on the centralized display 20. In embodiments not including player lamps, information identifying the designated gaming machine 12 may be displayed in the extra 16 lines *(e.g.,* section 24) of the 80 x 192 display described in relation to FIG. 3b. On the other hand, it is contemplated that when the display 20 is in the attract mode and not displaying a bonus round play from one of the associated game units, the computer 108 will be programmed to operate the relays to illuminate the player lamps 21 in a designated sequence or pattern.

The communications controller board 114 is also installed on the controller's back plane bus with the computer 108, and is memory mapped in the computer's I/O space. One RS-232 port (not shown) from the communications controller board is coupled to each of the game units for communications at 9600 baud with an 8 bit, no parity, one stop bit data format. The communications controller 114 will buffer messages received from the individual game units until the computer 108 is able to process the message. In order to accommodate the boards 110, 112 and 114 as well as the computer board 108, the computer chassis includes a 4 slot ISA passive back plane.

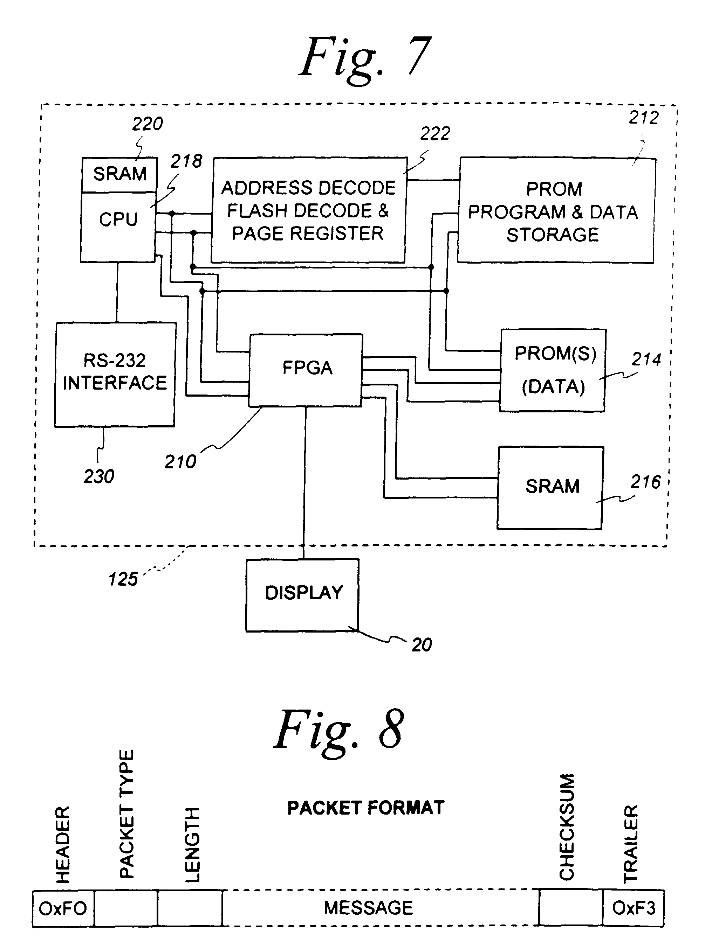

In one embodiment, the display controller 125 takes the form shown in FIG. 7, which is a somewhat modified version of one form of local video display controller 30 (FIG. 2) utilized by the applicant's assignee to display secondary or bonus displays in the individual gaming machines 12 as described above. This local display/controller 30 is based on a 68 HC11 processor and uses a Xilinx 3030 field programmable gate array (FPGA) to provide the logic for the display interface, the interface to external SRAM and bank switching for external PROM. In one embodiment, the FPGA 210 used for the display controller 125 will comprise a somewhat larger FPGA, such as one available from Actel. Otherwise, the basic components are the same for both display controllers 30, 125. In one embodiment, the program PROM 212 and data PROM(s) 214 of the central display controller 125 will be identical to those of the game display controller 30. In another embodiment, the program PROM 212 is different, but the data PROM(s) are identical to corresponding memory sections of the game display controller. The FPGA 210 provides the interface to the SRAM 216 and the bank switching for the PROM(s) 214 as well as the interface to the LED display of the display panel 20, controlling the data flow to the display and providing any required timing signals. Briefly, in the controller 125 of FIG. 7, the FPGA 210 is operatively coupled, as indicated, with the display 20 and also with PROM(s) 214, SRAM 216 and with CPU 218. An address decode, flash decode and page register 222 is also operatively coupled with the CPU for addressing the PROM 212. The CPU 218 communicates with the RS-232 interface 130 of FIG. 6 through its corresponding RS-232 interface 230.

Referring to FIG. 8, one possible packet format for the display is illustrated. This communications protocol is used to monitor the operation of the individual gaming machines 12, and particularly for transfer of the display information or dot matrix display protocol over the data lines 32 to the communications port header 104. The packet format includes initial header, packet type and packet length bytes, followed by the data or information or "message" as it is designated in FIG. 8. A following trailer byte and checksum byte complete the packet. The checksum byte should equal the sum of the byte values including the header and the trailer. The data carried in the packet type byte will include at least four possible commands including a normal display command, a starting bonus round command, a "total rebuild" command and an ending bonus round command. When a bonus game is not being played on any of the game units, the controller will send a sequence of display commands to the LED display controller 125, which will utilize information and the PROM 214 of the controller of FIG. 7 to drive the display in an attract mode.

In operation, the controller will operate in one of two modes depending on the communications received from the individual game units. If the communications received from the game units indicate that none of the game units is currently in a bonus mode, the controller will operate the display 20 and the speaker system 42 in the attract mode. If any of the game units indicate that a bonus round is beginning, the controller will then operate in a feature mode in which it will track the communications from the game unit or units which are in a bonus mode and forward the data received from one of these units to the LED display controller 125, causing the display 20 to "feature" the secondary or bonus display of one of the individual games which is in the bonus mode.

Operation of the display 20 is controlled by serial communications using essentially the same protocol as used by the individual game units or gaming machines 12 to drive their local bonus displays 14.

Preferably, the controller software is designed to operate on an embedded PC compatible hardware platform sucn as the IND-486 DX computer described above.

The controller software operates in a multi-tasking environment under the control of a real time Kernel. The incorporation of a real-time Kernel permits the software to be designed and written in a modular fashion to improve overall performance of the system, simplify error recovery procedures and provide code that is easy to maintain and modify. The software for the controller is organized into the following tasks: supervisor task, LED display interface task, game unit interface task, audio control task, and lamp control task.

The supervisor task will control the operation of the controller making decisions as to the mode of operation, either attract mode or feature mode, based on the information received from the game unit interface task. The supervisor task builds and maintains an activity table indicating the current state of each game unit. From this table, the supervisor task determines the current mode of operation and causes the proper commands to be sent to the display 20.

The display interface task provides the communications interface to the display controller 125 via the serial communications port 130. The information to be sent is controlled by the supervisor task. As the mode of the system changes, the display interface task will receive intertask messages from the supervisor task indicating the number of the message buffer to send to the controller. The display interface task reformats the packet protocol received from the game units (see FIG. 8) into the protocol for sending the commands to the display controller 125.

The game unit interface task provides the communications interface to the game units via the communications ports of the header 104. As messages are received from the game units, the message content will be placed in a buffer specific to the port on which the message was received. The game unit interface task will notify the supervisor task of changes in mode of operation of the game units via intertask messaging.

The audio control task provides the software interface to the hardware (relays 38) which will switch the incoming audio signal from the game units to the audio amplifier 40. The supervisor task will send intertask messages indicating which channel (that is, the audio signal from which game unit) to connect. Provision may also be made for selecting other audio information (not shown) for use in the attract mode.

The lamp control task provides the software interface to the hardware (lamp relay 120) which will provide power to the player lamps 21 (FIG. 2). The supervisor task will send intertask messages to the lamp control task indicating the mode of operation. During the attract mode, the lamp control task may sequence the player lamps 21 in some predetermined fashion to provide a combined display together with the attract display provided on the display unit 20 and a desired audio to be played on the speaker(s) 42 when in the attract mode.

Now turning to FIG. 9, there is shown a block diagram of a gaming system with a centralized mechanical display. Because the system of FIG. 9 shares several common features with the system of FIG. 2, like reference numerals will be employed to the greatest extent practical between FIGs. 2 and 9. Like the system of FIG. 2, the gaming system of FIG. 9 includes a plurality of gaming machines 12a, 12b ... 12p, each including a processor CPU 1, CPU 2, etc. (designated by reference numerals 26a, 26b ... 26p), a local display 14 (designated by reference numerals 14a, 14b ... 14p), and a display controller/driver 30 (designated by reference numerals 30a, 30b ... 30p). The gaming machines 12 may comprise any game of chance or skill utilizing a CPU 26 and a local display 14. The local display 14 may comprise a mechanical display (such as a spinning reel display), a video display (such as a dot matrix, CRT or electro-luminescent display), or a combination of video and mechanical displays. The display controller/driver 30 may comprise a mechanical display driver (for a local mechanical display) and/or a video display controller (for a local video display). The gaming machines 12 may be provided in fewer or greater numbers than shown in FIG. 9.

As in the system of FIG. 2, serial data cables 28a, 28b ... 28p connect the CPU 26 to the display controller/driver 30 in each of the gaming machines 12. The data cables 28, which may comprise RS-232 cables or the equivalent, support bi-directional communication between the CPU 26 and the display controller/driver 30 at a rate of 9600 baud, or approximately 1,000 bytes every second. In each gaming machine 12, the CPU 26 sends display information to the local display controller/driver 30 via the data cable 28. The display information includes operating commands for controlling a video and/or mechanical display of the gaming machines 12 and for specifying modes of operation of the gaming machines 12 *(e.g.,* instructing the gaming machines to operate in "basic" or "bonus" mode).

Where the gaming machines 12 have local video displays, the display information includes packetized graphics instructions which specify, for example, frame animations, sprite animations, text printing and text banners to be displayed by the local video display controller 30. Where the gaming machines 12 have mechanical displays, the display information includes operating instructions for actuating elements of the mechanical display such as, for example, control signals specifying reel starting and stopping conditions of a spinning reel display. The graphics and/or mechanical display to be displayed by the gaming machines 12 may be associated with either a "basic" game or "bonus" game of the gaming machines 12.

In one embodiment of the present invention, the CPU 26 provides a combination of both video and mechanical display information to the display controller/driver 30 in each gaming machine 12. The video display information comprises packetized graphics instructions specifying frame animations, sprite animations, text printing and text banners to be displayed by gaming machines having a local video display, whereas the mechanical display information includes instructions for actuating the mechanical display in gaming machines having a local mechanical display. The mechanical instructions may include, for example, control signals specifying reel starting and stopping conditions of a spinning reel display.

The display controller/driver 30 in each gaming machine 12 is adapted to execute the video or mechanical operating instructions appropriate to its local display. Thus, the display controller/driver 30 in gaming machines 12 having local video displays execute the video operating instructions to operate their respective video displays and the display controller/driver 30 in gaming machines 12 having local mechanical displays execute the mechanical operating instructions to operate their respective mechanical displays. Display controller/drivers 30 in gaming machines having both local video and mechanical displays may simultaneously execute both the video and mechanical operating instructions to operate their respective video and mechanical displays.

In the system of FIG. 9, a gaming system controller 15 and a display driver 50 links the gaming machines 12 to a centralized mechanical display 20. The display driver 50 controls operation of the centralized mechanical display 20 in response to instructions from the controller 15. The centralized mechanical display 20 may comprise any type of mechanical display including, for example, a spinning reel display (FIG. 10). The gaming system controller 15 and display driver 50 may comprise physically different units, or may be contained within a single structure such as a personal computer. The gaming machines 12 may also be linked to a plurality of player lamps 21 which may comprise, for example, incandescent lamps. The player lamps 21, is used, are linked to the system controller 15 by a plurality of lamp relays 120. In one embodiment, the player lamps 21 correspond in number to the number of gaming machines 12 and are positioned near the centralized display 20. For example, the player lamps 21 may be positioned adjacent to *(e.g.,* on top of or below) the centralized display 20 The player lamps 21 may be selectively illuminated under operative control of the gaming system controller 15 to supplement the centralized display 20. It will be appreciated, however, that the centralized display 20 may be utilized with or without player lamps 21, or the player lamps 21 may be positioned apart from the centralized display 20. For example, player lamps 21 may be positioned on top each of the gaming machines 12 in addition to, or instead of player lamps 21 positioned adjacent to the centralized display 20.

Data cables 32, which may comprise RS-232 cables or the equivalent, support bi-directional communication between the CPU 26 and the controller 15 at a rate of 9600 baud, or approximately 1.000 bytes every second. Each of the gaming machines 12 sends packetized display information, including operating commands for controlling a mechanical display and for specifying modes of operation of the gaming machines 12, to the controller 15 in substantially the same manner as to its local display controller/driver 30. The controller 15 receives and evaluates the display information in substantially the same manner described in relation to FIG. 2. Thus, for example, the controller 15 may designate an "active" machine and "feature" the display of the active machine in a feature mode upon receiving a "start bonus round" packet from one of the gaming machines 12. The controller may exit the feature mode upon receiving an "end bonus round" packet or upon receiving an information packet instructing the controller to preempt a currently active display.

In one embodiment, where the local display 14 of the "active" machine 12 comprises a mechanical display (or a mechanical display in combination with a video display), the display information provided to the centralized display 20 includes mechanical commands substantially the same as those provided to the local mechanical display 14 of the active machine 12. The mechanical commands provided to the local mechanical display 14 or the centralized mechanical display 20 may be provided exclusively or in combination with video operating commands. In either case, the mechanical commands cause the centralized display 20 to operate in substantially the same manner as the local mechanical display 14. Thus, for example, where both the local mechanical display 14 and centralized mechanical display 20 comprise spinning reel displays, the reel stopping positions of the centralized mechanical display 20 will correspond to the reel stopping positions of the local mechanical display 14.

In one embodiment, where the local display 14 of the "active" machine 12 does not have a mechanical display *(e.g.,* where the local display 14 comprises only a video display), the display information provided to the centralized display 20 includes mechanical commands which are generated by the active machine but not provided to the local display 14 of the active machine 12. Alternatively, the mechanical commands may be provided to but not executed by the local display or local display controller/dnver 30 of the active machine 12. The mechanical commands provided to the local display 14 or the centralized video display 20 may be provided exclusively or in combination with video operating commands.

It will be appreciated that the mechanical commands provided to the centralized display 20 may specify different operating instructions than those provided to the display controller/drivers 30 in the gaming machines 12. This may be the case where the centralized display 20 does not correspond exactly in type or form to the local display. For example, where the arrangement of symbols on a centralized spinning reel display do not correspond exactly to the symbols of a local mechanical display, different operating instructions may be required to cause the same symbols to be displayed on the centralized and local displays. Moreover, the mechanical commands provided to the centralized display may include supplemental information to be shown by the centralized display which may include, for example, an identification of the machine number playing the active game or a win amount associated with the active game.

As in the system of FIG. 2, an audio switch 38 links an audio output of the designated "active" gaming machine 12 to an amplifier 40 and speakers 42. The audio switch receives audio outputs from the gaming machines 12 through respective line-level audio feeds 34a, 34b ... 34p. The audio switch 38 is operated by the controller 15 to switch the audio output of the designated "active" machine 12 to the amplifier 40 and speakers 42 for broadcast. If no machines 12 are active, the controller 15 may cause the audio switch 38 to feed the speakers 42 an audio output associated with a predefined attract mode sequence.

FIG. 10 illustrates an embodiment of a centralized mechanical display 20 comprising a spinning reel display. The centralized spinning reel display 20 is generally larger than, but otherwise includes generally the same type of components and operates in substantially the same manner as the spinning reel display described in relation to FIGs. 4 and 5. Similar to the display of FIGs. 4 and 5, the centralized spinning reel display 20 includes a display window 60' through which a player may observe three spinning reels, 62', 64' and 66'. The display driver 50 operates to select a reel stop position for each of reels 62', 64' and 66'.

A centralized spinning reel display 20 of the type shown in FIG. 10 may be actuated in response to mechanical commands from a designated gaming machine having a local mechanical or video display, as heretofore described. The designated gaming machine may operate in a standard or bonus mode. More particularly, the centralized spinning reel display may be used to replicate an actual spinning reel display in a gaming machine having a local spinning reel display, or may execute mechanical commands provided, but not used, by a gaming machine having a local video display. In the latter case, execution of the mechanical commands may cause the centralized spinning reel display to replicate a simulated spinning reel display on the local video display.

As with the centralized video display, it is generally preferred that the centralized mechanical display 20 be sized and/or located to provide greater visibility relative to the local displays 14, so that the game activity displayed on the centralized display 20 (which may include "basic" or "bonus" game activity) may be more easily observed, or observed by a greater number of persons than would be able to see the designated gaming machines 12 and their local displays 14. Such greater visibility may be achieved, for example, by providing a centralized display 20 which is larger than the local displays 14 or by positioning the centralized display 20 above the local displays 14.

While the present invention has been described with reference to one or more particular embodiments, those skilled in the art will recognize that many changes may be made thereto without departing from the spirit and scope of the present invention. Each of these embodiments and obvious variations thereof is contemplated as falling within the spirit and scope of the claimed invention, which is set forth in the following claims.

## Claims

1. A gaming system comprising:
a plurality of gaming machines;
a centralized display; and
a controller linking the gaming machines to the centralized display, the controller being operable to obtain local display information from a selected one of the gaming machines and communicate corresponding display information to the centralized display.

2. The gaming system of claim I wherein the gaming machines are operable in a standard mode and a bonus mode, the controller obtaining local display information from a gaming machine operating in the bonus mode and communicating corresponding display information to the centralized display.

3. The gaming system of claim 1 wherein the local display information includes video display information for operating a video display.

4. The gaming system of claim 3 wherein the video display information includes graphical information.

5. The gaming system of claim 3 wherein the local display information further includes mechanical display information for operating a mechanical display.

6. The gaming system of claim 3 wherein the centralized display comprises a video display, the controller being operable to obtain the video display information from the selected gaming machine and communicate the video display information to the centralized display.

7. The gaming system of claim 6 wherein the centralized video display compnses a rectangular matrix of LED elements.

8. The gaming system of claim 7 wherein the centralized video display matrix is at least 192 elements wide and at least 64 elements high.

9. The gaming system of claim 8 wherein the centralized video display matrix is 192 elements wide and 80 elements high.

10. The gaming system of claim 1 wherein the local display information includes mechanical display information for operating a mechanical display.

11. The gaming system of claim 10 wherein the local display information further includes video display information for operating a video display.

12. The gaming system of claim 10 wherein the centralized display comprises a mechanical display, the controller being operable to obtain the mechanical display information from the selected gaming machine and communicate the mechanical display information to the centralized display.

13. The gaming system of claim 12 wherein the centralized display comprises a spinning reel display.

14. The gaming system of claim 1 further comprising audio switching means for linking an audio output associated with the selected gaming machine to a speaker associated with the centralized display.

15. The gaming system of claim I wherein each of the gaming machines includes memory means for storing data information for operating its local display, and wherein the controller includes memory means for storing the same data information for operating said centralized display.

16. The gaming system of claim 15 wherein the memory means of the gaming machines and the memory means of the controller are identical.

17. The gaming system of claim 15 wherein the memory means in each of the gaming machines includes program information for operating its local display, and wherein the memory means in the controller includes the same program information for operating said centralized display.

18. The gaming system of claim 17 wherein the memory means of the gaming machines and the memory means of the controller are identical.

19. The gaming system of claim I wherein the centralized display has a width of at least four feet.

20. A gaming system comprising:
a gaming machine;
a centralized display; and
a controller linking the gaming machine to the centralized display, the controller being operable to obtain local display information from the gaming machine and communicate corresponding display information to the centralized display.

21. A gaming system controller for linking a plurality of gaming machines to a centralized display, the controller comprising:
a communications interface for receiving game activity information from the gaming machines; and
a processor for evaluating the game activity information to identify any of the gaming machines operating in a preferred mode, the processor designating one of the machines identified as operating in the preferred mode, the processor obtaining display information from the designated machine and communicating corresponding display information to the centralized display.

22. The gaming system controller of claim 21 further comprising an audio controller responsive to said processor for linking an audio output of the designated machine to a speaker.

23. The gaming system controller of claim 21 further comprising a lamp controller responsive to said processor for illuminating a lamp associated with the designated machine.

24. The gaming system controller of claim 21 wherein the display information obtained from the designated machine includes video display information for operating a video display.

25. The gaming system controller of claim 24 wherein the video display information obtained from the designated machine includes graphical information.

26. The gaming system controller of claim 21 wherein the display information obtained from the designated machine includes mechanical display information for operating a mechanical display.

27. The gaming system controller of claim 21 wherein the gaming machines are operable in a bonus mode, the designated machine comprising a machine operating in said bonus mode.

28. The gaming system controller of claim 21, the processor being operable in an attract mode when none of the gaming machines are identified as operating in said preferred mode, the processor triggering display of attract mode information on the centralized display when in said attract mode.

29. The gaming system controller of claim 28 wherein operation in the attract mode terminates when one or more of the gaming machines are identified as entering said preferred mode.

30. The gaming system controller of claim 28, the processor including means for producing audio information when in said attract mode, the audio information being adapted for communication to a speaker to produce an audio output associated with said attract mode.

31. A method of linking a plurality of gaming machines to a centralized display, the method comprising the steps of:
receiving game activity information from the plurality of gaming machines;
evaluating the game activity information to identify modes of operation of the gaming machines:
selecting a gaming machine operating in a preferred mode;
obtaining display information from the selected gaming machine; and
displaying corresponding display information on the centralized display.

32. The method of claim 31 further comprising the step of playing an audio output associated with the selected gaming machine on a speaker associated with the centralized display.

33. The method of claim 31 wherein the centralized display comprises a video display, the display information obtained from the selected gaming machine including video display information for operating the centralized video display.

34. The method of claim 31 wherein the centralized display comprises a mechanical display, the display information obtained from the selected gaming machine including mechanical display information for operating the centralized mechanical display.

35. A method of linking a plurality of gaming machines to a centralized display, the gaming machines being adapted for operation in a basic mode and a bonus mode, the method comprising the steps of:
(a) receiving game activity information from the plurality of gaming machines;
(b) evaluating the game activity information to determine whether any of the gaming machines are operating in the bonus mode;
(c) if a positive determination is made in step (b),
(1) designating a selected gaming machine operating in the bonus mode as an active machine;
(2) obtaining display information from the active machine; and
(3) displaying corresponding display information on the centralized display.

36. The method of claim 35 further comprising the steps of:
(d) monitoring the game activity information to determine when the selected machine ceases operation in the bonus mode;
(e) redesignating the selected gaming machine as an inactive machine when the selected machine ceases operation in the bonus mode;
(f) terminating the display of display information associated with the inactive machine on the centralized display; and
(g) repeating steps (a), (b) and (c).

37. The method of claim 35 further comprising the step of broadcasting an audio output associated with the active machine if a positive determination is made in step (b).

38. The method of claim 35 further comprising the step of displaying attract mode information on the centralized display if a negative determination is made in step (b).
